# EUROPÄISCHE PATENTSCHRIFT

(11) **EP 2 292 440 B1**
(45) Veröffentlichungstag und Bekanntmachung des Hinweises auf die Patenterteilung: **20.03.2013**
(21) Anmeldenummer: 10174968.7
(22) Anmeldetag: 01.09.2010
(51) Int. Cl.: B41N 1/24, H05K 3/12

(54) **Stufenschablone für den technischen Siebdruck**
Layer template for technical screen printing
Cartouche à étages pour la sérigraphie technique

(30) Priorität: 07.09.2009 DE 202009012063 U; 16.12.2009 DE 202009016959 U
(43) Veröffentlichungstag der Anmeldung: 09.03.2011
(73) Patentinhaber: Becktronic GmbH, 57520 Derschen (DE)
(72) Erfinder: Schulte-Brinker, Thomas, 57462 Olpe (DE)
(74) Vertreter: Beck, Alexander

(56) Entgegenhaltungen:
- DE-A1- 1 960 723
- US-A- 3 668 028
- US-B1- 6 406 988

## Beschreibung

### Technisches Gebiet

Die vorliegende Erfindung betrifft eine Stufenschablone für den technischen Siebdruck mit Öffnungen und Bereichen mit verringerter Dicke.

Solche Stufenschablonen haben sich im technischen Siebdruck, insbesondere bei der Herstellung so genannter gedruckter Schaltungen sehr bewährt. Besonders vorteilhaft sind solche Stufenschablonen einzusetzen, wenn mit Leitpaste gleichzeitig Leiterbahnen und Durchkontaktierungen gedruckt werden sollen und/oder zur gleichzeitigen Aufbringung von örtlich unterschiedlichen Mengen von Leitpaste, da mittels Stufenschablonen unterschiedliche Mengen an Leitpaste im Bereich der Leitungen und im Bereich der Durchkontaktierungen in einem einzigen Druckvorgang gedruckt werden können. Weiterhin sind solche Stufenschablonen vorteilhaft, wenn gedruckte Widerstände mit stark unterschiedlichen Widerstandswerten realisiert werden sollen. In solchen Fällen kann es besonders vorteilhaft sein, wenn man mehrere verschiedene Stärken, also Dicken der gedruckten Lage herstellen kann. Zu diesem Zweck dienen Stufenschablonen mit mehreren, unterschiedlich stark eingetieften Bereichen.

### Stand der Technik

Solche Stufenschablonen, die bereits mehrere, unterschiedlich stark eingetiefte Bereiche aufweisen, sind erstmals in der DE 199 23 166 A1 vorgeschlagen worden.

Die dort vorgeschlagenen Folien wurden durch Aufeinanderkleben unterschiedlich ausgeschnittener Kunststofffolien hergestellt. Das heißt, hier wurde die Stufenschablone mühsam aus einzelnen Folien, die jeweils aus dem gleichen Material bestehen, aufgebaut. Dies ist ein mühsamer Prozess, und insbesondere ist die entsprechende Passung, das heißt das lage- und winkelrichtige Aufkleben der entsprechenden Folien aufeinander sehr schwierig. Aus diesem Grunde hat sich die Lösung gemäß DE 199 23 166 A1 nicht durchgesetzt.

Bisher war jedoch die Herstellung solcher Stufenschablonen problematisch und mühsam. Ein Überblick über den diesbezüglichen Stand der Technik befindet sich beispielsweise in der DE 10 2005 016 027 A1, die selbst vorschlägt, die Bereiche mit verringerter Dicke durch Hochgeschwindigkeitsfräsen herzustellen.

Es wurde beispielsweise vorgeschlagen, nachträglich in die hergestellten Ausnehmungen wieder dünnere Materialbereiche einzusetzen, Ätztechniken anzuwenden oder sogar die Bereiche erhöhter Dicke durch Aufwachsen mittels eines chemischen Abscheideprozesses herzustellen.

Aus der US 3,668,028 A und der DE 1 960 723 A1 ist bereits eine Stufenschablone für den technischen Siebdruck mit Öffnungen und Bereichen mit verringerter Dicke bekannt, wobei das Grundmaterial der Stufenschablone aus zwei übereinanderliegenden Schichten mit unterschiedlichen physikalischen und/oder chemischen Eigenschaften besteht, wobei die Öffnungen durch Laser hergestellt sein können, und die Bereiche verringerter Dicke durch ein Verfahren hergestellt sind, welches nur eine der Schichten aufgrund ihrer speziellen chemischen oder physikalischen Eigenschaft angreift.

Ausgehend von diesem Stand der Technik ist es daher Aufgabe der vorliegenden Erfindung, erstmals mehrstufige Stufenschablonen zur Verfügung zu stellen.

Erfindungsgemäß wird diese Aufgabe durch den Gegenstand des Anspruchs 1 gelöst. Die Unteransprüche zeigen vorteilhafte Weiterbildungen der Erfindung.

Dabei wird diese Aufgabe dadurch gelöst, dass die Stufenschablone aus jeweils mehreren, abwechselnd angeordneten Schichten mit unterschiedlichen physikalischen und/oder chemischen Eigenschaften besteht, und die Stufen durch Verfahren hergestellt sind, die jeweils nur eine Schicht aufgrund ihrer jeweiligen speziellen chemischen oder physikalischen Eigenschaften angreift.

Dabei wird diese Anfgabe gelöst, wenn die Stufenschablone aus jeweils mehr als einer Kunststoff- und mehr als einer Metallschicht besteht und Kunststoff- und Metallschichten abwechselnd übereinander angeordnet sind. Auf diese Weise kann der Abtrag einer Stufe jeweils mit klar unterschiedlichen Techniken erfolgen, da Metall und Kunststoff jeweils durch völlig andere Materialbehandlungen abgetragen werden können. Dennoch wird vermieden, dass eine Vielzahl verschiedener Abtrageverfahren zur Herstellung der Schablone eingesetzt werden müssen, wie dies der Fall wäre, wenn jede Schicht aus einem anderen Material bestünde. Durch die abwechselnde Anordnung kann beispielsweise die Metallschicht durch Ätzen, die dann anschließende Kunststoffschicht durch Lasern und sodann die nächste Metallschicht wieder durch Ätzen abgetragen werden, wodurch eine sehr präzise und vielfältige Abstufung der Stufenschablone erstmals ermöglicht wird.

Im Einsatzfall des technischen Siebdrucks ist es dabei besonders bevorzugt, dass als letzte rakelseitige Schicht eine Metallschicht und als letzte druckstückseitige Schicht eine Kunststoffschicht angeordnet ist.

Erfindungsgemäß können also durch unterschiedliche physikalische oder chemische Behandlung unterschiedlich viele Schichten abgetragen sein, wodurch sehr viele unterschiedliche Tiefen für die Ausnehmungen in der Stufenschablone realisiert werden können.

Besonders bevorzugt ist es, wenn die unterschiedliche physikalische Behandlung jeweils aus einer Laserbestrahlung besteht, diese aber unterschiedliche Lichtfrequenzen oder Lichtfarben und/oder unterschiedliche Intensitäten aufweist. Auf diese Weise lässt sich die höchste Präzision bei der Herstellung der Stufenschablone erzielen.

### Kurze Beschreibung der Abbildungen der Zeichnungen

Die vorliegende Erfindung wird im Folgenden anhand des in den Zeichnungen dargestellten Ausführungsbeispiels näher erläutert. Es zeigt:

Fig. 1 einen Ausschnitt aus einer Stufenschablone von der der zu bedruckenden Oberfläche zugewandten Seite;

Fig. 2 den Ausschnitt der Figur 1 von der Rakelseite; und

Fig. 3 den Schnitt A-A der Figur 2.

Fig. 4 einen Ausschnitt aus einer weiteren erfindungsgemäßen Stufenschablone von der Druckstückseite her gesehen;

Fig. 5 den Ausschnitt der Figur 4 von der Rakelseite aus gesehen;

Fig. 6 den Schnitt A-A der Figur 5.

### Bester Weg zur Ausführung der Erfindung

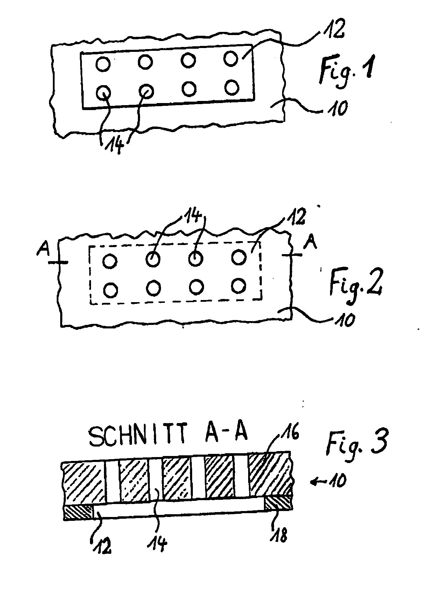

Figur 1 zeigt einen kleinen Ausschnitt aus einer Siebdruckschablone 10 von der zu bedruckenden Oberfläche aus gesehen. Dieses kleine Stück der Druckschablone 10 weist eine länglich-rechteckige Vertiefung 12 auf, in der wiederum vollständige Durchbrüche 14 vorgesehen sind. Durch die Durchbrüche 14 wird das zu druckende Material auf die zu bedruckende Oberfläche gedrückt. Es füllt dabei die Ausnehmung 12, wodurch eine definierte Form des aufgedruckten Materials hergestellt wird.

Figur 2 zeigt den gleichen Ausschnitt 10 aus einer erfindungsgemäßen Stufenschablone von der Rakelseite aus gesehen. Die Vertiefung 12 ist hier nicht sichtbar und deshalb nur gestrichelt angedeutet, die Öffnungen 14, die durch die gesamte Schablone hindurch reichen, sind wieder sichtbar.

Figur 3 zeigt den Schnitt A-A der Figur 2.

Dabei wird gut erkennbar, wie die erste Schicht 16 der Schablone 10 lediglich in den völligen Durchbrüchen 14 unterbrochen ist, während die zweite Schicht 18 aus einem anderen, leichter oder mit anderen Methoden zu entfernenden Material im gesamten Bereich 12 unterbrochen beziehungsweise abgetragen ist.

Vorzugsweise wählt man für die Schichten 16, 18 entweder unterschiedliche Metalllegierungen, oder die Schicht 16 besteht aus einem Metall und die Schicht 18 aus einem Kunststoff. Letztere kann nämlich mit einem UV-Laser leicht abgetragen werden, während der UV-Laser Metallschichten wie die Schicht 16 kaum angreift.

Beim Drucken mit der Stufenschablone läuft die Rakel dann oberhalb der Schicht 16 und drückt die Druckpaste durch die Öffnungen 14 in den Hohlraum 12, wo die Paste mit der zu bedruckenden Oberfläche in Berührung kommt. Die Ausnehmung 12 bildet dabei einen Formraum, der den Auftrag der Lötpaste auf die zu bedruckende Oberfläche exakt begrenzt. Im Übrigen liegt die Stufenschablone 10 mit der Oberfläche der zweiten Schicht 18 auf der zu bedruckenden Oberfläche auf.

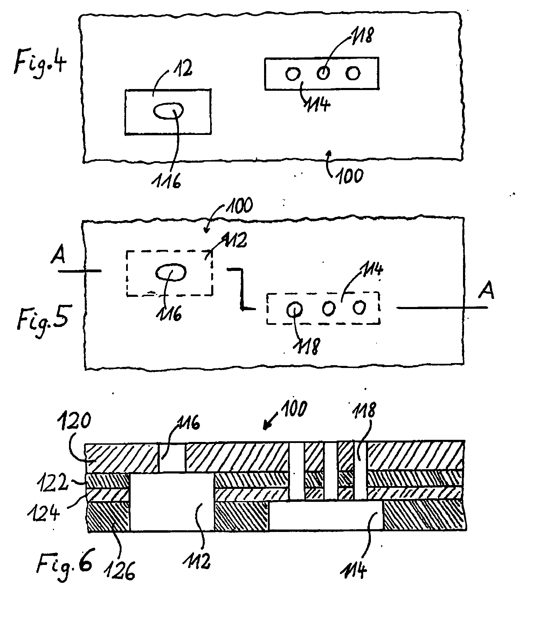

Figur 4 zeigt einen kleinen Ausschnitt aus einer erfindungsgemäßen Siebdruckschablone 100 von der zu bedruckenden Oberfläche aus gesehen. Dieses kleine Stück der Druckschablone 100 weist eine tiefe rechteckige Vertiefung 112 und eine weniger tiefe länglich-rechteckige Vertiefung 114 auf. Beide Vertiefungen sind mit runden Öffnungen 116, 118 versehen, die durch die ganze Schablone 100 hindurch bis zu der rakelseitigen Oberfläche reichen.

Durch diese Öffnungen 116, 118 wird dann während des Siebdruckvorganges die Paste in die Vertiefungen 112, 114 gedrückt.

Figur 5 zeigt den Ausschnitt der Figur 4 aus der weiteren erfindungsgemäßen Stufenschablone 100 von der anderen Seite, also von der Rakelseite aus. Hier sind die Vertiefungen 112, 114 natürlich nicht sichtbar, sie sind daher zur besseren Orientierung des Betrachters gestrichelt angedeutet. Tatsächlich sichtbar sind nur die Öffnungen 116, 118.

Figur 6 zeigt den Schnitt A-A durch das in Figur 5 dargestellte Stückchen einer erfindungsgemäßen Stufenschablone 100.

Wie in Figur 6 sehr schön zu erkennen, besteht die hier dargestellte erfindungsgemäße Stufenschablone 100 aus insgesamt 4 Schichten:

Einer rakelseitig angeordneten, stärkeren (dickeren) Metallschicht 120,

einer druckstückseitig davon angeordneten dünnen Kunststoffschicht 122, einer druckstückseitig an diese anschließenden dünnen Metallschicht 124; und schließlich einer druckstückseitig abschließenden dickeren Kunststoffschicht 126, mit der die Stufenschablone beim Drucken auf dem Druckstück aufliegt.

In dem flachen, vertieften Bereich 114 ist, wie aus Figur 6 sehr schön zu erkennen, lediglich die dicke Kunststoffschicht 126 entfernt, während in dem tiefen, vertieften Bereich 112 sowohl die dicke Kunststoffschicht 126 als auch die dünne Metallschicht 124 und die dünne Kunststoffschicht 122 entfernt sind.

Im Bereich der Durchbrüche 116, 118 sind natürlich alle Schichten entfernt, da sonst eine Zuführung der zu druckenden Paste in die Vertiefungen 112, 114 nicht möglich wäre.

Vorliegend ist ein Aufbau der Stufenschablone aus vier Schichten 120, 122, 124, 126 dargestellt. Selbstverständlich kann eine erfindungsgemäße Schablone auch weitere Schichten aufweisen, sodass erfindungsgemäß auch ein 6-, 8- oder 10-schichtiger Aufbau denkbar ist, wenn noch mehrere unterschiedliche Abstufungen in der Druckdicke erforderlich sind. Dies kann beispielsweise beim Drucken von Widerständen von Vorteil sein.

Die erfindungsgemäße, hier dargestellte Struktur kann beispielsweise dadurch hergestellt werden, dass die Kunststoffschicht 126 in den Bereichen 112 und 114 durch einen UV-Laser abgetragen wird. Metallschichten wie die Schichten 120, 124 greift ein solcher Laser kaum an. Im Bereich 112 kann dann die dünne Metallschicht 124 weggeätzt werden, während ein Zutritt der Ätzflüssigkeit in die Ausnehmung 114 beispielsweise durch eine geeignete Abdeckung dieser Ausnehmung verhindert wird. Sodann kann auch noch die Kunststoffschicht 122 wiederum durch einen UV-Laser bis auf die Metallschicht 120 abgetragen werden.

Die Öffnungen 116, 118 können dann durch einen entsprechend leistungsstärkeren Laser durch das Metall "durchgeschossen" werden.

Beim Drucken der erfindungsgemäßen Stufenschablone 100 läuft die Rakel oberhalb der Schicht 120 und drückt die Druckpaste durch die Öffnungen 116, 118 in die Hohlräume 112, 114, wo die Paste mit der zu druckenden Oberfläche in Berührung kommt. Die Ausnehmungen 112, 114 bilden dabei unterschiedlich hohe Formräume, durch die der Auftrag der zu verdruckenden Paste auf die zu bedruckende Oberfläche exakt auf zwei unterschiedliche Stärken begrenzt. Im Übrigen liegt beim Druckvorgang die erfindungsgemäße Stufenschablone 100 mit der Oberfläche der Schicht 126 auf der zu bedruckenden Oberfläche auf.

## Patentansprüche

1. Stufenschablone (100) für den technischen Siebdruck, die aus abwechselnd angeordneten Schichten (120, 122, 124, 126) mit unterschiedlichen physikalischen und/oder chemischen Eigenschaften besteht und bei der die Stufen (112, 114) durch Abtragen jeweils nur einer Schicht (120, 122, 124, 126) hergestellt sind, **dadurch gekennzeichnet, dass** sie aus jeweils mehr als einer Kunststoff- (122, 126) und mehr als einer Metallschicht (120, 124) besteht, und Kunststoff-(122, 126) und Metallschichten (120, 124) abwechselnd übereinander angeordnet sind.

2. Stufenschablone (100) nach Anspruch 1, **dadurch gekennzeichnet, dass** rakelseitig eine Metallschicht (120) und druckstückseitig eine Kunststoffschicht (126) angeordnet ist.

3. Stufenschablone (100) nach Anspruch 1 oder 2, **dadurch gekennzeichnet, dass** durch unterschiedliche physikalische oder chemische Behandlung unterschiedlich viele Schichten (122, 124, 126) abgetragen sind, wodurch die unterschiedlich tiefen Ausnehmungen (112, 114) in der Stufenschablone (100) gebildet sind.

4. Stufenschablone (100) nach Anspruch 3, **dadurch gekennzeichnet, dass** die unterschiedliche physikalische Behandlung jeweils aus einer Laserbestrahlung besteht, diese aber unterschiedliche Lichtfrequenzen oder Lichtfarben und/oder unterschiedliche Intensitäten aufweist.

## Claims

1. Stepped stencil (100) for technical screen printing, consisting of alternatingly arranged layers (120, 122, 124, 126) having different physical and/or chemical properties, and in which the steps (112, 114) are produced by removing only one layer (120, 122, 124, 126) each, **characterized in that** it consists of more than one plastics layer (122, 126) and more than one metal layer (120, 124), respectively, and that layers of plastics (122, 126) and metal (120, 124) are arranged one upon the other in an alternating manner.

2. Stepped stencil as claimed in claim 1, **characterized in that** a metal layer (120) is arranged on the side facing the blade and a plastics layer (126) is arranged on the side facing the object to be printed.

3. Stepped stencil as claimed in claim 1 or 2, **characterized in that** a different number of layers (122, 124, 126) is removed by different physical or chemical treatments so that recesses (112, 114) of different depth are formed in the stepped stencil (100).

4. Stepped stencil as claimed in claim 3, **characterized in that** said different physical treatments in each case comprise a laser irradiation which, however, have different light frequencies or color temperatures and/or different intensities.

## Revendications

1. Pochoir à étages (100) pour la sérigraphie technique, lequel est constitué de couches (120, 122, 124, 126) qui ont des propriétés physiques et/ou chimiques différentes et sont agencées en alternance, les étages (112, 114) étant fabriqués par enlèvement à chaque fois d'une seule couche (120, 122, 124, 126), **caractérisé en ce qu'**il est constitué à partir à chaque fois de plus d'une couche en plastique (122, 126) et de plus d'une couche en métal (120, 124) et **en ce que** les couches en plastique (122, 126) et les couches en métal (120, 124) sont agencées en alternance les unes au-dessus des autres.

2. Pochoir à étages (100) selon la revendication 1, **caractérisé en ce qu'**une couche en métal (120) est agencée côté racle et une couche en plastique (126) côté pièce d'impression.

3. Pochoir à étages (100) selon la revendication 1 ou 2, **caractérisé en ce que** des couches (122, 124, 126) en différents nombres sont enlevées par un traitement physique ou chimique différent, les évidements (112, 114) de profondeurs différentes étant ainsi formés dans le pochoir à étages (100).

4. Pochoir à étages (100) selon la revendication 3, **caractérisé en ce que** le traitement physique différent réside respectivement dans une irradiation au laser, celle-ci ayant toutefois des fréquences ou des couleurs de lumière différentes et/ou des intensités différentes.
